# FASCICULE DE BREVET EUROPEEN

(11) **EP 1 784 871 B1**
(45) Date de publication et mention de la délivrance du brevet: **18.07.2012**
(21) Numéro de dépôt: 05731968.3
(22) Date de dépôt: 03.05.2005
(51) Int. Cl.: H01L 31/032, H01L 31/18, C30B 7/00, C30B 29/46

(54) **PROCEDE POUR PRODUIRE UN COMPOSE CHALCOPYRITE EN COUCHE MINCE**
VERFAHREN ZUR HERSTELLUNG EINER DÜNNFILM-KUPFERKIES-ZUSAMMENSETZUNG
METHOD FOR PRODUCING A THIN-FILM CHALCOPYRITE COMPOUND

(30) Priorité: 03.05.2004 CH 783042004
(43) Date de publication de la demande: 16.05.2007
(73) Titulaire: SOLARONIX SA, 1170 Aubonne (CH)
(72) Inventeur: MEYER, Tobias, CH-1173 Féchy (CH); AYODHYA, Tiwari, CH-8051 Zürich (CH); KAELIN, Marc Roland, CH-8037 Zürich (CH)
(74) Mandataire: Nithardt, Roland
(86) Numéro de dépôt international: PCT/IB2005/051437
(87) Numéro de publication internationale: WO 2005/106967

(56) Documents cités:
- WO-A-96/06454
- US-A- 4 368 216
- PENNDORF J ET AL: "CuInS2 thin film formation on a Cu tape substrate for photovoltaic applications" SOLAR ENERGY MATERIALS AND SOLAR CELLS, ELSEVIER SCIENCE PUBLISHERS, AMSTERDAM, NL, vol. 53, no. 3-4, juin 1998 (1998-06), pages 285-298, XP004148855 ISSN: 0927-0248
- WENG S ET AL: "Preparation of copper indium diselenide by selenisation of copper indium oxide" JOURNAL OF APPLIED PHYSICS, AMERICAN INSTITUTE OF PHYSICS. NEW YORK, US, vol. 74, no. 3, 1 août 1993 (1993-08-01), pages 2046-2052, XP002078864 ISSN: 0021-8979
- BOIKO M E ET AL: "Thermal oxidation of CuInSe2: Experiment and physico-chemical model" SOLAR ENERGY MATERIALS AND SOLAR CELLS, ELSEVIER SCIENCE PUBLISHERS, AMSTERDAM, NL, vol. 41-42, juin 1996 (1996-06), pages 307-314, XP004007949 ISSN: 0927-0248
- OLIVEIRA M C F ET AL: "A voltammetric study of the electrodeposition of CuInSe2 in a citrate electrolyte" PREPARATION AND CHARACTERIZATION, ELSEVIER SEQUOIA, NL, vol. 405, no. 1-2, 22 février 2002 (2002-02-22), pages 129-134, XP004342255 ISSN: 0040-6090

## Description

### Domaine technique

La présente invention concerne un procédé pour produire une couche mince de chalcopyrite sur un substrat, notamment pour une utilisation dans les cellules photovoltaïques, ce substrat étant constitué, par exemple, de molybdène déposé en couche mince sur du verre ou un polymère, dans lequel l'on dépose sur ledit substrat au moins un film liquide mince d'une solution, l'on sèche ledit film liquide afin d'obtenir une couche solide recouvrant ledit substrat, et l'on forme la chalcopyrite par réaction thermique en mettant en contact ladite couche solide avec une atmosphère contenant au moins un élément du Groupe 16 du Tableau Périodique des Eléments.

### Technique antérieure

Les composés chalcopyrites, en particulier le diséléniure de cuivre et d'indium CulnSe₂, aussi appelé CIS, et ses alliages avec du gallium ("CIGS") et du soufre ("CIGSS") sont des candidats prometteurs lorsque utilisés comme couche absorbante de lumière dans des cellules photovoltaïques, dites en couches minces.

Le brevet US 4,335,266 décrit la technologie des cellules CIS. Grâce à leur coefficient d'absorption élevé, une épaisseur de 1 à 2 µm de chalcopyrite CIGS est suffisante pour absorber toute la lumière incidente. En changeant le rapport In/Ga et Se/S, une large gamme de valeurs (1 à 2.4 eV) de la lacune d'énergie ("band-gap") peut être obtenue, et des structures avec une lacune d'énergie graduelle sont employées dans des cellules photovoltaïques à haut rendement. Des cellules solaires possédant une couche de CIGS polycristallin ont montré des rendements de conversion dépassant les 19%, comme décrit par K. Ramanathan et al., Photovoltaics, 2003, 11, p. 225. Les premières industries sont apparues et leur production de cellules solaires en couches minces CIGS est basée sur des procédés de co-évaporation et de sélénisation nécessitant un vide poussé, comme décrit par Powalla et al., Proceedings of the 3rd WCPEC, Osaka, Japan, 2003, en publication et par Kushiya et al., Proceedings of the 3rd WCPEC, Osaka, Japan 2003, en publication. Les modules solaires CIGS actuels ont des rendements moyens de 10 à 13%, le but étant d'obtenir 13 à 15% avec des coûts de production inférieurs à ceux du silicium cristallin. Ces modules CIGS à haut rendement sont obtenus avec des équipements sous vide coûteux et des contrôles de procédés sophistiqués. En outre une perte de 20 à 40% des matières premières est inévitable. Afin de réduire les coûts de fabrication, des méthodes de dépôt alternatives basées sur des procédés ne faisant pas appel au vide poussé ont été proposées et étudiées. En général, ces méthodes devraient permettre le dépôt rapide et simple de la couche de chalcopyrite CIGS avec l'utilisation complète des matières premières telles que l'indium et le gallium, des éléments assez rares et coûteux. A part les méthodes bien connues, telles que les procédés électrochimiques, décrit par exemple par le brevet US 5 871 630, et la pyrolyse par sprayage, décrite par exemple par les brevets US 4 242 374 ou US 6 379 635, les méthodes basées sur le dépôt d'une pâte ont attiré l'attention ces dernières années, puisque des rendements supérieurs à 13% ont été obtenus comme décrit dans le brevet US 6 127 202. Kapur et al. ont développé un procédé où une pâte contenant les oxydes métalliques en poudre nanocristalline est d'abord déposée sur le substrat par étalement ("doctor-blade"), puis un traitement en atmosphère d'hydrogène permet la réduction des oxydes en une couche métallique, qui elle est ensuite chauffée dans une atmosphère diluée de H₂Se. Ce procédé nécessite, d'une part, l'élaboration des poudres nanométriques d'oxyde métallique ayant le rapport Cu/In et Cu/Ga adéquat et, d'autre part, la réduction en atmosphère hydrogénée suivie par la "sélénisation" nécessite au moins deux enceintes sous vide chauffées pour assurer la sécurité, étant donné que le gaz H₂Se employé est fortement toxique, ce qui renchérit le procédé. En outre, le fait de devoir traiter le dépôt de pâte d'oxyde métallique en deux étapes rallonge considérablement le temps de cycle nécessaire pour obtenir la couche mince de chalcopyrite.

Dans un autre procédé décrit dans le brevet US 5 910 336, des composés organométalliques sont dissous dans un solvant organique, puis déposés sur le substrat par tournette ("spin-coating") ou par plongée ("dip-coating"), et après la pyrolyse en atmosphère inerte ou réductrice, l'alliage métallique ainsi obtenu est sélénisé dans un four, et la couche de chalcopyrite ainsi formée est complétée en cellules solaires ayant un rendement jusqu'à 9%. Ce procédé nécessite aussi des précurseurs métallo-organiques assez toxiques et coûteux, et le procédé en deux étapes (réduction, puis sélénisation) pénalise aussi la vitesse de dépôt et renchérit les coûts.

La publication PENNDORF J. et AL dans SOLAR ENERGY MATERIALS AND SOLAR CELLS ELSEVIER SCIENCE PUBLISHERS, AMSTERDAM NL, vol. 53, n° 3-4, juin 1998, concerne la formation d'une cellule solaire à hétérojonction entre le CulnS₂ (type n) et le Cu(O,S) (type p) fabriquée par sulfurisation d'une couche d'indium déposée galvaniquement (à partir d'une solution de sulfate d'indium) sur une bande de cuivre. Pendant ce procédé rapide (quelques secondes), la bande de cuivre recouverte d'indium est chauffée à 600° C en atmosphère d'azote, la fusion de l'indium permettant la diffusion rapide de cuivre, et en même temps la bande est exposée à de la vapeur de soufre ce qui permet la conversion de l'alliage Cu-In formé en CulnS₂ avec une couche supérieure de CuS, qui est ensuite enlevée par attaque chimique au KCN. La couche barrière Cu(O,S) est déposée par décomposition thermique d'une solution d'acétate de cuivre et de thiourée à ∼300° C.

Le procédé de l'invention diffère de ce procédé par la manière par laquelle la couche de chalcopyrite est obtenue. Au lieu d'utiliser une bande de cuivre recouverte d'une couche d'indium déposée par galvanoplastie l'invention utilise un précurseur liquide contenant un solvant polaire, des sels métalliques et un liant organique, ce précurseur étant déposé par une méthode d'impression sur un substrat approprié et séché puis soumis à un traitement de sulfurisation/sélénisation, qui peut être semblable à celui décrit dans le document de Penndorf et al., bien que les réactions chimiques soient différentes.

La publication de WENG S. et AL dans JOURNAL OF APPLIED PHYSICS, AMERICAN INSTITUTE OF PHYSICS, NEW YORK, vol. 74, n° 3, 1 août 2003 a pour objet la formation de CulnSe₂ par la sulfurisation de couches de Cu₂In₂O₅ dans des vapeurs de sélénium, ces couches de Cu₂In₂O₅ étant préparées par pyrolyse d'une solution de nitrates/chlorure de cuivre et d'indium déposée par sprayage sur les substrats chauffée à 150° C. Généralement un recuit des couches d'oxydes est fait dans l'air à 500° C avant la sélénisation.

Comme pour le document précédent, le procédé de l'invention diffère du procédé décrit par la manière de déposer la couche de chalcopyrite. Au lieu de faire réagir sur un substrat adéquat une solution de précurseurs pour y former des oxydes de cuivre et d'indium (qui sont ensuite sélénisés), un précurseur liquide contenant un solvant polaire, des sels métalliques et un liant organique est déposé sur un substrat approprié et séché (sans réactions chimiques). La sélénisation qui s'en suit peut être semblable, bien que les réactions chimiques soient différentes (dans le cas de l'invention il n'y a pas d'oxydes métalliques qui sont transformés en sélénures).

Le brevet US 4 368 216 concerne un procédé permettant la formation d'un semi-conducteur ou d'une couche contenant un semi-conducteur. Ce procédé requiert la préparation d'un mélange pâteux contenant une poudre (particules moulues) du semi-conducteur que l'on veut déposer, un agent de flux (sel métallique), et un liquide approprié, mélangé occasionnellement avec un agent tensioactif. Ce mélange pâteux peut être déposé sur un substrat conducteur électriquement, puis ce substrat est soumis à la chaleur et la pression afin de dissoudre une partie de la poudre de semi-conducteur dans l'agent de flux pour y former une couche semi-conductrice par frittage.

Dans le procédé selon l'invention le matériau de départ n'est pas solide mais est préparé à partir de sels complètement dissous, un solvant polaire et un liant organique. En outre, le chalcogénure est formé par réaction chimique subséquente (sélénisation / sulfurisation), tandis que dans le brevet cité tous les réactifs sont déjà présents dans le mélange initial, principalement sous forme de poudre de semi-conducteurs.

La publication de BOIKO M. E. et AL dans SOLAR ENERGY MATERIALS AND SOLAR CELLS ELSEVIER SCIENCE PUBLISHERS, AMSTERDAM NL, vol. 41-42, juin 1996 concerne des monocristaux de CuInSe₂ qui sont oxydés thermiquement et dont sont étudiées la structure, ainsi la décomposition du composé ternaire, la croissance d'une couche d'oxyde d'indium à la surface des cristaux de CulnSe₂ et l'observation de la formation d'une couche intermédiaire de composition variable.

Cette publication n'a pas de point commun avec le procédé de l'invention où il n y a pas d'oxydation d'un chalcogénure.

La publication OLIVEIRA M. C. F. et Al., dans THIN SOLID FILMS, ELSEVIER SEQUOIA, NL, vol 405, n° 1-2, 22 février 2002, décrit la formation de couches de CulnSe₂ sur des substrats de verre recouverts de molybdène par dépôt galvanique (électrodéposition) dans une solution contenant de l'acide citrique, du nitrate de cuivre, du chlorure d'indium et du dioxyde de sélénium.

Dans le procédé de l'invention, au lieu de réduire les ions métalliques contenus dans les sels pour y déposer une couche métallique sur le substrat recouvert de molybdène, une solution de précurseur est préparée à partir de sels métalliques complètement dissous, un solvant polaire et un liant organique, et cette solution est ensuite déposée sous forme d'un film liquide, puis séchée et ensuite convertie en CulnSe₂ par sélénisation.

La publication internationale WO 96/06454 A décrit la formation de couches de Cu(ln,Ga)Se₂ légèrement appauvries en cuivre par déposition des précurseurs Cu, In, Ga (par évaporation sous vide selon l'exemple 1), suivi de leur recuit en présence de sélénium pour y former du Cu(In,Ga)Se₂ et du Cu₂₋ₓSe, puis d'un dépôt additionnel d'indium et de gallium et un recuit.

Dans le procédé de l'invention, au lieu de déposer le Cu, In Ga par évaporation sous vide, une solution de précurseur contenant les sels métalliques, un solvant polaire et un liant organique, est déposée sur un substrat approprié et séchée, puis ce dépôt est converti en CulnSe₂ par réaction chimique dans la vapeur de sélénium.

### Exposé de l'invention

La présente invention se rapporte à un procédé rapide et économe en matières premières, et nécessitant des équipements simples pour produire une couche mince de chalcopyrite sur un substrat.

Ce but est atteint par le procédé selon la revendication 1 tel que défini en préambule et caractérisé en ce que ladite solution est constituée d'au moins un sel minéral d'un métal entrant dans la composition de la chalcopyrite et d'un liant organique, dissous dans un solvant polaire, et en ce qu'elle est déposée sur le substrat par un procédé d'impression choisi parmi la sérigraphie, le stencil, le sprayage, la tournette, la tampographie, la flexographie les méthodes d'étalement d'un film liquide telles que le "doctor blade" ou le "cup-coating", afin d'obtenir une couche solide du sel minéral dudit métal

De façon avantageuse, le au moins un sel minéral dissous est un sel d'un métal choisi parmi le cuivre, l'argent, le fer, le zinc, l'étain, le cadmium, l'aluminium, le gallium, l'indium, l'antimoine et le bismuth.

Dans une forme de réalisation du procédé, ladite solution contient au moins un sel minéral d'un métal choisi parmi les Groupes 11 et 12 du Tableau Périodique des Eléments, et au moins un sel minéral d'un métal choisi parmi les Groupes 13 et 14 du Tableau Périodique des Eléments. Elle peut donc contenir au moins un sel minéral d'un métal choisi parmi le cuivre, l'argent, le zinc, le cadmium, et au moins un ou plusieurs métaux choisis parmi l'aluminium, le gallium, l'indium et l'étain.

De préférence, ledit sel minéral contient au moins un anion choisi parmi les halogénures, le nitrate, le cyanure, le cyanate, le thiocyanate, le sélénocyanate, le chlorure et le nitrate. Elle peut donc contenir au moins du nitrate ou du chlorure de cuivre anhydre ou hydraté et au moins un ou plusieurs métaux choisis parmi l'aluminium, le gallium et l'indium, sous la forme de sels minéraux tels que soit sous forme de nitrate, soit sous forme de chlorure, anhydre ou hydraté, notamment du nitrate de cuivre (II) anhydre ou hydraté, du chlorure d'indium (III) anhydre ou hydraté et du nitrate de gallium (III) anhydre ou hydraté.

De façon avantageuse, le liant organique est un mélange formé d'au moins deux composés organiques choisis parmi les celluloses, les celluloses substituées, les alkylcelluloses, les alcools polyvinyliques, les polyéthylèneoxydes, les polyacrylonitriles, les polysaccharides et les nitrocelluloses

Le solvant polaire peut être choisi parmi l'eau et les composés organiques tels que les alcools aliphatiques, les nitriles, les polyglycols, les polyéthers, les polyols, les esters, les éthers, les cétones, les diols et les alcools alcoxyles, notamment le méthanol, l'éthanol, le 1-propanol, le 2-propanol, le 1-pentanol, le 1,2-propanediol, le 1,3-propanediol, la glycérine, du diglyme, le tétraglyme, l'acétonitrile, le propionitrile et le 3-methoxypropionitrile.

Dans ce cas, le solvant polaire de ladite solution peut être un mélange d'eau et d'un ou plusieurs composés organiques choisis parmi les alcools aliphatiques, les nitriles, les polyglycols, les polyéthers, les polyols, les esters, les éthers, les cétones, les diols et les alcools alcoxyles.

Le solvant polaire de ladite solution peut également être est un mélange formé d'au moins deux composés organiques choisis parmi les alcools aliphatiques, les nitriles, les polyglycols, les polyéthers, les polyols, les esters, les éthers, les cétones, les diols et les alcools alcoxyles.

Dans une forme préférée de mise en oeuvre du procédé selon l'invention, ladite solution contient au moins du nitrate de cuivre (II) anhydre ou hydraté dans une concentration de 0.05 à 3 molaire, de préférence 0.2 à 1 molaire, du chlorure d'indium (III) anhydre ou hydraté dans une concentration de 0.03 à 3 molaire, de préférence 0.2 à 1 molaire, et du nitrate de gallium (III) anhydre ou hydraté dans une concentration de 0 à 1 molaire, de préférence 0 à 0.4 molaire, et comme liant organique au moins un type d'éthylcellulose dans une concentration de 2 à 200 g/l, de préférence 50 à 150 g/l, dissous dans du méthanol, ou dissous dans un mélange de méthanol et de 1-pentanol.

Ledit film de solution déposé sur le substrat est avantageusement séché en le chauffant progressivement jusqu'à une température comprise entre 150° et 300°C dans une atmosphère neutre ou à l'air libre pour obtenir une couche solide.

Ladite couche solide recouvrant le substrat est transformée en chalcopyrite par réaction thermique effectuée à une température comprise entre 300° et 650° C, de préférence 500 et 600° C, en mettant en contact pendant un temps compris entre 1 et 30 minutes, de préférence 5 et 20 minutes, ladite couche solide dans une atmosphère contenant au moins un élément tel que du sélénium, du soufre ou du tellure, ou un mélange de ces trois éléments à l'état élémentaire.

La chalcopyrite obtenue selon le procédé de l'invention peut être du tellurure de cadmium (CdTe) ou du CuInₓGa_{y}Se₂, avec la somme x+y située entre 0.8 et 1.5 et avec y situé entre 0 et 0.6.

### Manière(s) de réaliser l'invention

L'invention concerne un procédé pour produire une couche mince de chalcopyrite sur un substrat selon la revendication 1, ce substrat constitué, par exemple, de molybdène déposé en couche mince sur du verre ou un polymère, dans lequel l'on dépose sur ledit substrat au moins un film liquide mince d'une solution, l'on sèche ledit film liquide afin d'obtenir une couche solide recouvrant ledit substrat, et l'on forme la chalcopyrite par réaction thermique en mettant en contact ladite couche solide dans une atmosphère contenant au moins un élément du Groupe 16 du Tableau Périodique des Eléments, ladite solution étant constituée d'au moins un sel minéral d'un métal entrant dans la composition de la chalcopyrite et d'un liant organique, dissous dans un solvant polaire.

Le sel ou les sels minéraux présents sont des sels des métaux choisis parmi les métaux des Groupes 3 à 15 du Tableau Périodique des Eléments, sous forme de sels minéraux. Ils peuvent être choisis parmi les métaux de transition et les métaux des Groupes 11 à 15 du Tableau Périodique, un ou plusieurs métaux étant choisis parmi les Groupes 11 et 12, et au moins un ou plusieurs métaux étant choisis parmi les Groupes 13 et 14, par exemple au moins un métal faisant partie du Groupe 11, et au moins un métal faisant partie du Groupe 13. Ces divers métaux sont notamment le cuivre, l'argent, le fer, le zinc, l'étain, le cadmium, l'aluminium, le gallium, l'indium, l'antimoine et le bismuth.

Par ailleurs ledit sel minéral contient au moins un anion choisi parmi les halogénures, le nitrate, le cyanure, le cyanate, le thiocyanate et le sélénocyanate et parmi le chlorure et le nitrate. Ainsi, la solution peut contenir, par exemple, au moins du nitrate ou du chlorure de cuivre anhydre ou hydraté et au moins un ou plusieurs métaux choisis parmi l'aluminium, le gallium et l'indium, soit sous forme de nitrate, soit sous forme de chlorure, anhydre ou hydraté, tel que du nitrate de cuivre (II) anhydre ou hydraté, du chlorure d'indium (III) anhydre ou hydraté et du nitrate de gallium (III) anhydre ou hydraté ou au moins du nitrate de cadmium (II) anhydre ou hydraté, ou du chlorure de cadmium (II) anhydre ou hydraté.

Le liant organique est choisi parmi les celluloses, les celluloses substituées, les alkylcelluloses, les alcools polyvinyliques, les polyéthylène oxydes, les polyacrylonitriles, les polysaccharides, les éthylcelluloses et les nitrocelluloses solubles dans un solvant adéquat. Il peut être un mélange formé d'au moins deux des ces composés organiques.

Le solvant polaire de ladite solution est choisi parmi l'eau et les composés organiques tels que les alcools aliphatiques, les nitriles, les polyglycols, les polyéthers, les polyols, les esters, les éthers, les cétones, les diols et les alcools alcoxyles. Le solvant peut être un mélange d'eau et d'un ou de plusieurs de ces composés organiques. Il peut également être un mélange formé d'au moins deux desdits composés organiques. A titre d'exemple le solvant polaire de ladite solution est choisi parmi l'eau, le méthanol, l'éthanol, le 1-propanol, le 2-propanol, le 1-pentanol, le 1,2-propanediol, le 1,3-propanediol, la glycérine, du diglyme, le tétraglyme, l'acétonitrile, le propionitrile et le 3-methoxypropionitrile, ou parmi le méthanol, l'éthanol, le 1-pentanol et le 1,2-propanediol.

La solution peut ainsi contenir au moins du nitrate de cuivre (II) anhydre ou hydraté dans une concentration de 0.05 à 3 molaire, de préférence 0.2 à 1 molaire, du chlorure d'indium (III) anhydre ou hydraté dans une concentration de 0.03 à 3 molaire, de préférence 0.2 à 1 molaire, et du nitrate de gallium (III) anhydre ou hydraté dans une concentration de 0 à 1 molaire, de préférence 0 à 0.4 molaire, et comme liant organique au moins un type d'éthylcellulose dans une concentration de 2 à 200 g/l, de préférence 50 à 150 g/l, dissous dans du méthanol, ou dissous dans un mélange de méthanol et de 1-pentanol.

Ladite solution peut également être est obtenue en dissolvant dans du méthanol d'abord du nitrate de gallium(III) hydraté dans une concentration de 0.04 molaire, puis du chlorure d'indium(III) anhydre dans une concentration de 0.16 molaire, puis du nitrate de cuivre(II) hémipentahydrate dans une concentration de 0.2 molaire et finalement une quantité de 120 g/l d'éthylcellulose ayant une viscosité standardisée de 5-15 mPas (mesurée à 25° C à une teneur de 5 % dans un mélange toluène/EtOH 80:20).

En variante, ladite solution peut contenir dans un rapport 1 à 2 une solution A et une solution B. La solution A est constituée de 5 ml de méthanol contenant 0.767 g de nitrate de gallium(III) hydraté, 0.885 g de chlorure d'indium(III) anhydre et 0.938 g de nitrate de cuivre(II) hémipentahydrate, et la solution B est préparée avec 5 ml de 1-pentanol contenant 0.767 g de nitrate de gallium(III) hydraté, 0.885 g de chlorure d'indium(III) anhydre, 0.938 g de nitrate de cuivre(II) hémipentahydrate et 0.5 g d'éthylcellulose ayant une viscosité standardisée de 5-15 mPas (mesurée à 25°C à une teneur de 5 % dans un mélange toluène/EtOH 80:20).

La solution est déposée sur le substrat par un procédé d'impression tel que la sérigraphie, le stencil, le sprayage, la tournette ("spin-coating") la tampographie, la flexographie, ou des méthodes d'étalement d'un film liquide ("doctor-blade" ou "cup-coating"), consistant à étaler la solution sur le substrat avec une racle qui glisse sur des espaceurs situé de part et d'autre de la surface utile et qui imposent l'épaisseur du film liquide déposé, ou avec une combinaison de plusieurs procédés d'impression. En effet, toute méthode permettant le transfert d'un liquide sur une surface est utilisable, étant donné que la solution de sels métalliques minéraux contient aussi un liant organique qui permet d'ajuster la viscosité et la rhéologie de ladite solution afin d'être compatible avec la méthode d'impression ou de déposition choisie.

Ledit film de solution déposé sur le substrat est ensuite séché en chauffant progressivement jusqu'à une température comprise entre 150° et 300° C dans une atmosphère neutre ou à l'air libre. La couche solide ainsi formée recouvrant le substrat est transformée en chalcopyrite par réaction thermique effectuée à une température comprise entre 300° et 650° C, de préférence 500 et 600° C, en mettant en contact pendant un temps compris entre 1 et 30 minutes, de préférence 5 et 20 minutes, ladite couche solide dans une atmosphère contenant au moins un élément du Groupe 16 du Tableau Périodique des Eléments tel que du sélénium ou du soufre à l'état élémentaire, ou un mélange de sélénium et de soufre.

La chalcopyrite obtenue lorsque la solution contient du nitrate de cadmium(II) ou du chlorure de cadmium(II) anhydre ou hydraté est du tellurure de cadmium (CdTe). Lorsque la solution contient du nitrate de cuivre (II), du chlorure d'indium (III), et du nitrate de gallium (III) anhydre ou hydraté la chalcopyrite obtenue est du CulnₓGaySe₂, avec la somme x+y situé entre 0.8 et 1.5 et avec y situé entre 0 et 0.6.

Dans le cas où les sels contiennent du cuivre, de l'indium et éventuellement aussi du gallium dans les rapports atomiques adéquats, et que l'atmosphère du traitement thermique contient du sélénium, une chalcopyrite de type Cu(lnGa)Se₂ est obtenue ayant des propriétés physiques et électriques favorables pour la fabrication de cellules solaires photovoltaïques.

Le substrat ne se limite pas aux molybdène déposé sur du verre tel qu'utilisé dans les cellules photovoltaïques CIGS, tout substrat offrant la résistance chimique requise pendant le traitement thermique en atmosphère contenant le ou les éléments du Groupe 16 peut être recouvert d'une couche mince de chalcopyrite selon l'invention.

L'invention ne se limite pas qu'aux chalcopyrites du type CIGS, mais elle peut être étendue aux composés tels que le CdTe, HgCdTe ou le Cu₂ZnSnSe₄ par exemple. Des oxydes mixtes, tels que le CuAlO₂, voire par exemple des sulfides du type AglnS₂ sont aussi envisageables en utilisant les sels métalliques correspondants.

Les applications des chalcopyrites obtenues selon l'invention ne se limitent pas qu'aux applications de cellules solaires photovoltaïques et d'autres applications sont envisageables, par exemple les chalcopyrites peuvent servir de détecteurs infrarouges dans le cas du HgCdTe, de couches conductrices électriques transparentes dans le cas du CuAlO₂, de capteurs photovoltaïques dans le cas du CdTe, voire d'émetteurs de lumière dans des structures de diodes luminescentes, ou comme matériaux semi-conducteurs dans des résistances électriques ou même des transistors en utilisant des dopages adéquats. Si des métaux comme le Fe, Ni, Co, Cr entrent dans la composition de la chalcopyrite, des propriétés magnétiques sont aussi possibles.

Tous les exemples qui vont suivre ont été préparés à partir de lames de verre sodacalcique recouvertes d'une couche de molybdène déposée par pulvérisation cathodique. Les couches minces de chalcopyrites obtenues selon le procédé de l'invention ont servi dans des cellules photovoltaïques, étant donné que ces couches de chalcopyrites ont été optimisées et caractérisées pour cette application.

Le procédé selon l'invention comprend quatre étapes qui sont les suivantes:

### Etape 1

Préparation d'une solution contenant le ou les sels métalliques minéraux et le ou les liants organiques dissous dans un solvant polaire.

### Etape 2

Dépôt de cette solution sur le substrat par un moyen adéquat d'impression qui assure une épaisseur constante et définie un film liquide sur le substrat, le procédé d'impression choisi parmi les alternatives défini par la revendication 1.

### Etape 3

Séchage à l'air libre ou dans une atmosphère inerte du substrat avec son film liquide afin d'obtenir un film compact et solide contenant le ou les sels métalliques.

### Etape 4

Traitement thermique dans une atmosphère contenant le ou les éléments du Groupe 16 du Tableau Périodique afin de former la chalcopyrite.

Des exemples de production de chalcopyrite selon le procédé de la présente invention sont donnés ci-dessous à titre indicatif.

### Exemple 1

Dans un volume de 25 ml de méthanol (Fluka 99.5%) sont dissous 1.106 g de chlorure d'indium(III) anhydre InCl₃ (Aldrich, 99.999%), et 0.938 g de nitrate de cuivre(II) hémipentahydrate Cu(NO₃)₂.2.5 H₂O (Aldrich, 99.99%), puis 3 g d'éthylcellulose "Ethocel®" (Fluka) ayant une viscosité standardisée de 5-15 mPas sont ajoutés à la solution afin d'y ajuster la consistance.

Cette solution est déposée sur un verre recouvert de molybdène en étalant la solution avec une baguette de verre qui fait office de racle et en utilisant des espaceurs de 100 µm qui définissent l'épaisseur du film liquide ainsi obtenu. Un volume d'environ 1 ml de solution est suffisant pour 10 cm² de substrat. Le substrat avec le film de liquide est immédiatement séché à 100 - 120° C pendant 2 à 3 minutes, puis il est chauffé à 250° C à l'air pendant 1 à 2 minutes.

Finalement, ce substrat ainsi traité est mis dans une enceinte chauffée en graphite contenant 0.5 g de soufre (99.5%, Fluka) et après un temps de 10 minutes à 500° C, le substrat est recouvert d'une couche mince (environ 1 µm) de chalcopyrite CulnS₂ polycristalline. L'analyse par microscopie électronique à balayage, par EDX, et la diffraction de rayons X permettent l'identification de la chalcopyrite ainsi obtenue.

### Exemple 2

Dans un volume de 25 ml de méthanol (Fluka, 99.5%) sont dissous 0.256 g de nitrate de gallium(III) hydraté (99.999%, Aldrich), 0.885 g de chlorure d'indium(III) anhydre InCl₃ (Aldrich, 99.999%), ce qui permet un rapport atomique In/Ga de 4, et 0.938 g de nitrate de cuivre(II) hémipentahydrate Cu(NO₃)₂ 2.5 H₂O (Aldrich, 99.99%), ce qui permet un rapport atomique Cu/(In+Ga) de 1, puis 3 g d'éthylcellulose "Ethocel^{®}" (Fluka) ayant une viscosité standardisée de 5-15 mPas sont ajoutés à la solution afin d'en ajuster la consistance.

Comme dans l'exemple précédant, cette solution est déposée sur le verre recouvert de molybdène en étalant la solution avec une baguette de verre qui fait office de racle et en utilisant des espaceurs de 100 µm qui définissent l'épaisseur du film liquide ainsi obtenu. Le substrat avec le film de liquide est immédiatement séché à l'air en passant de la température ambiante à 120° C en 2 minutes, puis il est chauffé, toujours à l'air libre, de 120° C à 300° C en 3 minutes. Finalement, ce substrat ainsi traité est mis dans une enceinte tubulaire en verre remplie d'azote et maintenue à 10 mbars. Cette enceinte comportant deux zones de températures, le substrat est placé dans l'une des zones et une coupelle contenant 0.2 g de sélénium (99.9%, Aldrich) est placée dans l'autre zone. La zone avec le sélénium est maintenue à 300° C et le substrat est chauffé à 560° C pendant 10 minutes. Après ce traitement thermique, aussi appelé "sélénisation", le substrat est recouvert d'une couche mince (environ 1 µm) de chalcopyrite CuIn_{0.8}Ga_{0.2}Se₂ polycristalline ayant des propriétés photovoltaïques favorables.

### Exemple 3

Une première solution de 5 ml de méthanol (Fluka, 99.5%) contenant 0.767 g de nitrate de gallium(III) hydraté (99.999%, Aldrich), 0.885 g de chlorure d'indium(III) anhydre InCl₃ (Aldrich, 99.999 %) et 0.938 g de nitrate de cuivre(II) hémipentahydrate Cu(NO₃)₂ 2.5 H₂O (Aldrich, 99.99 %) est préparée. Une seconde solution est préparée avec 5 ml de 1-pentanol (99%, Fluka) contenant les mêmes quantités de sels métalliques que la première solution et contenant en plus 0.5 g d'éthylcellulose "Ethocel^{®}" (Fluka) ayant une viscosité standardisée de 5-15 mPas.

La solution à déposer est formulée en mélangeant dans un rapport 1 à 2 la première et la seconde solution, afin d'obtenir la viscosité et la rhéologie désirée.

Le dépôt sur le verre recouvert de molybdène, le séchage et la sélénisation se font comme décrit dans l'exemple 2. La chalcopyrite ainsi obtenue possède des propriétés photovoltaïques favorables, une fois qu'une mince couche de 50 nm de CdS y a été appliquée par le procédé bien connu du "bain chimique", suivi d'un contact transparent à base de ZnO dopé à l'aluminium déposé par pulvérisation cathodique. Une telle cellule photovoltaïque a montré un rendement de conversion de 6% sous l'éclairage standardisé de 1/000 W/m².

## Revendications

1. Procédé pour produire une couche mince de chalcopyrite sur un substrat, notamment pour une utilisation dans les cellules photovoltaïques, ce substrat étant constitué, par exemple, de molybdène déposé en couche mince sur du verre ou un polymère, dans lequel l'on dépose sur ledit substrat au moins un film liquide mince d'une solution, l'on sèche ledit film liquide afin d'obtenir une couche solide recouvrant ledit substrat, et l'on forme la chalcopyrite par réaction thermique en mettant en contact ladite couche solide avec une atmosphère contenant au moins un élément du Groupe 16 du Tableau Périodique des Eléments, **caractérisé en ce que** ladite solution est constituée d'au moins un sel minéral d'un métal entrant dans la composition de la chalcopyrite et d'un liant organique, dissous dans un solvant polaire, et **en ce qu'**elle est déposée sur le substrat par un procédé d'impression choisi parmi la sérigraphie, le stencil, le sprayage, la tournette, la tampographie, la flexographie et les méthodes d'étalement d'un film liquide telles que le "doctor blade" ou le "cup-coating", afin d'obtenir une couche solide du sel minéral dudit métal.

2. Procédé selon la revendication 1, **caractérisé en ce que** le au moins un sel minéral dissous est un sel d'un métal choisi parmi le cuivre, l'argent, le fer, le zinc, l'étain, le cadmium, l'aluminium, le gallium, l'indium, l'antimoine et le bismuth.

3. Procédé selon la revendication 1, **caractérisé en ce que** ladite solution contient au moins un sel minéral d'un métal choisi parmi les Groupes 11 et 12 du Tableau Périodique des Eléments, et au moins un sel minéral d'un métal choisi parmi les Groupes 13 et 14 du Tableau Périodique des Eléments.

4. Procédé selon la revendication 3, **caractérisé en ce que** ladite solution contient au moins un sel minéral d'un métal choisi parmi le cuivre, l'argent, le zinc, le cadmium, et au moins un ou plusieurs métaux choisis parmi l'aluminium, le gallium, l'indium et l'étain sous forme de sels minéraux.

5. Procédé selon la revendication 1, **caractérisé en ce que** ledit sel minéral contient au moins un anion choisi parmi les halogénures, le nitrate, le cyanure, le cyanate, le thiocyanate, le sélénocyanate, le chlorure et le nitrate.

6. Procédé selon la revendication 3, **caractérisé en ce que** ladite solution contient au moins du nitrate ou du chlorure de cuivre anhydre ou hydraté et au moins un ou plusieurs métaux choisis parmi l'aluminium, le gallium et l'indium, soit sous forme de nitrate, soit sous forme de chlorure, anhydre ou hydraté.

7. Procédé selon la revendication 6, **caractérisé en ce que** ladite solution contient au moins du nitrate de cuivre (II) anhydre ou hydraté, du chlorure d'indium (III) anhydre ou hydraté et du nitrate de gallium (III) anhydre ou hydraté.

8. Procédé selon la revendication 1, **caractérisé en ce que** le liant organique est un mélange formé d'au moins deux composés organiques choisis parmi les celluloses, les celluloses substituées, les alkylcelluloses, les alcools polyvinyliques, les polyéthylèneoxydes, les polyacrylonitriles, les polysaccharides et les nitrocelluloses

9. Procédé selon la revendication 1, **caractérisé en ce que** le solvant polaire de ladite solution est choisi parmi l'eau et les composés organiques tels que les alcools aliphatiques, les nitriles, les polyglycols, les polyéthers, les polyols, les esters, les éthers, les cétones, les diols et les alcools alcoxyles et notamment le méthanol, l'éthanol, le 1-propanol, le 2-propanol, le 1-pentanol, le 1,2-propanediol, le 1,3-propanediol, la glycérine, du diglyme, le tétraglyme, l'acétonitrile, le propionitrile et le 3-méthoxypropionitrile.

10. Procédé selon la revendication 1, **caractérisé en ce que** le solvant polaire de ladite solution est un mélange d'eau et d'un ou plusieurs composés organiques choisis parmi les alcools aliphatiques, les nitriles, les polyglycols, les polyéthers, les polyols, les esters, les éthers, les cétones, les diols et les alcools alcoxyles.

11. Procédé selon la revendication 1, **caractérisé en ce que** le solvant polaire de ladite solution est un mélange formé d'eau et d'au moins deux composés organiques choisis parmi les alcools aliphatiques, les nitriles, les polyglycols, les polyéthers, les polyols, les esters, les éthers, les cétones, les diols et les alcools alcoxyles.

12. Procédé selon la revendication 1, **caractérisé en ce que** ladite solution contient au moins du nitrate de cuivre (II) anhydre ou hydraté dans une concentration de 0.05 à 3 molaire, de préférence 0.2 à 1 molaire, du chlorure d'indium (III) anhydre ou hydraté dans une concentration de 0.03 à 3 molaire, de préférence 0.2 à 1 molaire, et du nitrate de gallium (III) anhydre ou hydraté dans une concentration de 0 à 1 molaire, de préférence 0 à 0.4 molaire, et comme liant organique au moins un type d'éthylcellulose dans une concentration de 2 à 200 g/l, de préférence 50 à 150 g/l, dissous dans du méthanol, ou dissous dans un mélange de méthanol et de 1-pentanol.

13. Procédé selon la revendication 1, **caractérisé en ce que** ledit film de solution déposé sur le substrat est séché en le chauffant progressivement jusqu'à une température comprise entre 150° et 300°C dans une atmosphère neutre ou à l'air libre pour obtenir une couche solide.

14. Procédé selon la revendication 1, **caractérisé en ce que** ladite couche solide recouvrant le substrat est transformée en chalcopyrite par réaction thermique effectuée à une température comprise entre 300° et 650° C, de préférence 500 et 600° C, en mettant en contact pendant un temps compris entre 1 et 30 minutes, de préférence 5 et 20 minutes, ladite couche solide avec une atmosphère contenant au moins un élément tel que du sélénium, du soufre ou du tellure, ou un mélange de ces trois éléments à l'état élémentaire.

15. Procédé selon les revendications 1 et 2, **caractérisé en ce que** la chalcopyrite obtenue est du tellurure de cadmium (CdTe).

16. Procédé selon les revendications 1 et 12, **caractérisé en ce que** la chalcopyrite obtenue est du CulnₓGa_{y}Se₂, avec la somme x+y située entre 0.8 et 1.5 et avec y situé entre 0 et 0.6.

## Claims

1. A method for producing a thin film of chalcopyrite on a substrate, in particular for use in photovoltaic cells, this substrate consisting, for example, of molybdenum deposited in a thin layer on glass or a polymer, in which at least a thin liquid film of a solution is deposited on the substrate, said liquid film is dried in order to obtain a solid layer covering the substrate, and the chalcopyrite is formed by thermal reaction by placing said solid layer in contact with an atmosphere containing at least one element from Group 16 of the Periodic Table of Elements, **characterized in that** said solution consists of at least one mineral salt of a metal entering into the chalcopyrite composition and of an organic binder, dissolved in a polar solvent, and **in that** said solution is deposited on the substrate by an impression method selected from serigraphy, stencilling, spraying, spin-coating, tampography, flexography, and methods for spreading a liquid film, such as "doctor-blade" or "cup-coating", in order to obtain a solid layer of the mineral salt of said metal.

2. A method according to claim 1, **characterized in that** the at least one dissolved mineral salt is a salt of a metal selected from copper, silver, iron, zinc, tin, cadmium, aluminium, gallium, indium, antimony and bismuth.

3. A method according to claim 1, **characterized in that** said solution contains at least one mineral salt of a metal selected from Groups 11 and 12 of the Periodic Table of Elements, and at least one mineral salt of a metal selected from Groups 13 and 14 of the Periodic Table of Elements.

4. A method according to claim 3, **characterized in that** said solution contains at least one mineral salt of a metal selected from copper, silver, zinc, cadmium and at least one or more metals selected from aluminium, gallium, indium and tin in the form of mineral salts.

5. A method according to claim 1, **characterized in that** said mineral salt contains at least one anion selected from halogens, nitrate, cyanide, cyanate, thiocyanate, selenocyanate, chloride and nitrate.

6. A method according to claim 3, **characterized in that** said solution contains at least nitrate or anhydrous or hydrated copper chloride and at least one or more metals selected from aluminium, gallium, and indium, either in the form of nitrate, or in the form of anhydrous or hydrated chloride.

7. A method according to claim 6, **characterized in that** said solution contains at least anhydrous or hydrated copper nitrate (II), anhydrous or hydrated indium chloride (III), and anhydrous or hydrated gallium nitrate (III).

8. A method according to claim 1, **characterized in that** the organic binder is a mixture formed of at least two organic compounds selected from celluloses, cellulose substitutes, alkylcelluloses, polyvinyl alcohols, polyethylene oxides, polyacrylonitriles, polysaccharides, and nitrocelluloses.

9. A method according to claim 1, **characterized in that** the polar solvent for said solution is selected from water and organic compounds such as aliphatic alcohols, nitriles, polyglycols, polyethers, polyols, esters, ethers, ketones, diols, and alkoxyalcohols and, in particular, methanol, ethanol, 1-propanol, 2-propanol, 1-pentanol, 1.2-propanediol, 1.3-propanediol, glycerin, diglyme, tetraglyme, acetonitrile, propionitrile and 3-methoxypropionitrile.

10. A method according to claim 1, **characterized in that** the polar solvent for said solution is a mixture of water and one or more organic compounds selected from aliphatic alcohols, nitriles, polyglycols, polyethers, polyols, esters, ethers, ketones, diols, and alkoxyalcohols.

11. A method according to claim 1, **characterized in that** the polar solvent for said solution is a mixture formed of water and at least two organic compounds selected from aliphatic alcohols, nitriles, polyglycols, polyethers, polyols, esters, ethers, ketones, diols, and alkoxyalcohols.

12. A method according to claim 1, **characterized in that** said solution contains at least anhydrous or hydrated copper nitrate (II) in a 0.05 to 3 molar concentration, preferably in a 0.2 to 1 molar concentration, anhydrous or hydrated indium chloride (III) in a 0.03 to 3 molar concentration, preferably in a 0.2 to 1 molar concentration, and anhydrous or hydrated gallium nitrate (III) in a 0 to 1 molar concentration, preferably in a 0 to 0.4 molar concentration, and as organic binder, at least one type of ethylcellulose in a 2 to 200 g/l concentration, preferably in a 50 to 150 g/l concentration, dissolved in methanol or dissolved in a mixture of methanol and 1-pentanol.

13. A method according to claim 1, **characterized in that** said film of solution deposited on the substrate is dried by progressively heating it to a temperature ranging from 150 to 300° C in a neutral atmosphere or in open air in order to obtain a solid layer.

14. A method according to claim 1, **characterized in that** said solid layer covering the substrate is transformed into chalcopyrite by a thermal reaction effected at a temperature ranging from 300 to 650° C, preferably between 500 and 600° C, by placing said solid layer in contact with an atmosphere containing at least one element such as selenium, sulfur or tellurium, or a mixture of these three elements, in the elementary state, for a period of time ranging from 1 and 30 minutes, preferably between 5 to 20 minutes.

15. A method according to claims 1 and 2, **characterized in that** the chalcopyrite obtained is cadmium telluride (CdTe).

16. A method according to claims 1 and 12, **characterized in that** the chalcopyrite obtained is CulnₓGa_{y}Se₂, with the sum x+y being between 0.8 and 1.5 and with y being between 0 and 0.6.

## Patentansprüche

1. Verfahren zur Herstellung einer Chalcopyrit-Dünnschicht auf einem Substrat, insbesondere für eine Verwendung in Sperrschichtphotozellen, wobei dieses Substrat beispielsweise aus Molybdän gebildet wird, das als Dünnschicht auf das Glas oder ein Polymer aufgebracht wurde, wobei in dem Verfahren mindestens ein dünner flüssiger Film aus einer Lösung auf das Substrat aufgebracht wird, der flüssige Film getrocknet wird, um eine feste Schicht zu erhalten, die das Substrat bedeckt, und das Chalcopyrit durch thermische Reaktion gebildet wird, indem die feste Schicht mit einer Atmosphäre in Kontakt gebracht wird, die mindestens ein Element der Gruppe 16 des Periodensystems der Elemente enthält,
**dadurch gekennzeichnet, dass**
die Lösung von mindestens einem Mineralsalz eines Metalls gebildet wird, das in die Zusammensetzung des Chalcopyrits und eines organischen Bindemittels eindringt und in einem polaren Lösungsmittel gelöst ist, und dass sie auf das Substrat durch ein Druckverfahren aufgebracht wird, das aus Siebdruck, Matrizendruck, Sprühen, Schleudern, Tampondruck, Flexodruck und Verfahren zur Verteilung eines flüssigen Films, wie "Rakel" oder "Becherbeschichtung", ausgewählt ist, um eine feste Schicht des Mineralsalzes des Metalls zu erhalten.

2. Verfahren nach Anspruch 1,
**dadurch gekennzeichnet, dass**
das mindestens eine gelöste Mineralsalz ein Salz eines Metalls ist, das aus Kupfer, Silber, Eisen, Zink, Zinn, Cadmium, Aluminium, Gallium, Indium, Antimon und Wismut ausgewählt ist.

3. Verfahren nach Anspruch 1,
**dadurch gekennzeichnet, dass**
die Lösung mindestens ein Mineralsalz eines Metalls, das aus den Gruppen 11 und 12 des Periodensystems der Elemente ausgewählt ist, und mindestens ein Mineralsalz eines Metalls, das aus den Gruppen 13 und 14 des Periodensystems der Elemente ausgewählt ist, enthält.

4. Verfahren nach Anspruch 3,
**dadurch gekennzeichnet, dass**
die Lösung mindestens ein Mineralsalz eines Metalls enthält, das aus Kupfer, Silber, Zink, Cadmium und mindestens einem oder mehreren Metallen ausgewählt ist, das bzw. die aus Aluminium, Gallium, Indium und Zinn in Form von Mineralsalzen ausgewählt ist bzw. sind.

5. Verfahren nach Anspruch 1,
**dadurch gekennzeichnet, dass**
das Mineralsalz mindestens ein Anion enthält, das aus Halogeniden, Nitrat, Cyanid, Cyanat, Thiocyanat, Selenocyanat, Chlorid und Nitrat ausgewählt ist.

6. Verfahren nach Anspruch 3,
**dadurch gekennzeichnet, dass**
die Lösung mindestens wasserfreies oder hydratisiertes Kupfernitrat oder - chlorid und mindestens ein oder mehrere Metalle, die aus Aluminium, Gallium und Indium entweder in Form eines wasserfreien oder hydratisierten Nitrats oder in Form eines wasserfreien oder hydratisierten Chlorids ausgewählt sind, enthält.

7. Verfahren nach Anspruch 6,
**dadurch gekennzeichnet, dass**
die Lösung mindestens wasserfreies oder hydratisiertes Kupfer(II)-nitrat, wasserfreies oder hydratisiertes Indium(III)-chlorid und wasserfreies oder hydratisiertes Gallium(III)-nitrat enthält.

8. Verfahren nach Anspruch 1,
**dadurch gekennzeichnet, dass**
das organische Bindemittel ein Gemisch ist, das aus mindestens zwei organischen Verbindungen, die aus Cellulosen, substituierten Cellulosen, Alkylcellulosen, Polyvinylalkoholen, Polyethylenoxiden, Polyacrylnitrilen, Polysacchariden und Nitrocellulosen ausgewählt sind, gebildet wird.

9. Verfahren nach Anspruch 1,
**dadurch gekennzeichnet, dass**
das polare Lösungsmittel der Lösung aus Wasser und organischen Verbindungen wie aliphatischen Alkoholen, Nitrilen, Polyglykolen, Polyethern, Polyolen, Estern, Ethern, Ketonen, Diolen und alkoxylierten Alkoholen und insbesondere Methanol, Ethanol, 1-Propanol, 2-Propanol, 1-Pentanol, 1,2-Propandiol, 1,3-Propandiol, Glycerin, Diglyme, Tetraglyme, Acetonitril, Propionitril und 3-Methoxypropionitril ausgewählt ist.

10. Verfahren nach Anspruch 1,
**dadurch gekennzeichnet, dass**
das polare Lösungsmittel der Lösung ein Gemisch von Wasser und einem oder mehreren organischen Verbindungen ist, die aus aliphatischen Alkoholen, Nitrilen, Polyglykolen, Polyethern, Polyolen, Estern, Ethern, Ketonen, Diolen und alkoxylierten Alkoholen ausgewählt sind.

11. Verfahren nach Anspruch 1,
**dadurch gekennzeichnet, dass**
das polare Lösungsmittel der Lösung ein Gemisch ist, das aus Wasser und mindestens zwei organischen Verbindungen, die aus aliphatischen Alkoholen, Nitrilen, Polyglykolen, Polyethern, Polyolen, Estern, Ethern, Ketonen, Diolen und alkoxylierten Alkoholen ausgewählt sind, gebildet wird.

12. Verfahren nach Anspruch 1,
**dadurch gekennzeichnet, dass**
die Lösung mindestens wasserfreies oder hydratisiertes Kupfer(II)-nitrat in einer Konzentration von 0,05 bis 3 Mol, vorzugsweise 0,2 bis 1 Mol, wasserfreies oder hydratisiertes Indium(III)-chlorid in einer Konzentration von 0,03 bis 3 Mol, vorzugsweise 0,2 bis 1 Mol und wasserfreies oder hydratisiertes Gallium(III)-nitrat in einer Konzentration von 0 bis 1 Mol, vorzugsweise 0 bis 0,4 Mol und als Bindemittel mindestens einen Ethylcellulose-Typ in einer Konzentration von 2 bis 200 g/l, vorzugsweise 50 bis 150 g/l, der in Methanol gelöst ist oder in einem Gemisch von Methanol und 1-Pentanol gelöst ist, enthält.

13. Verfahren nach Anspruch 1,
**dadurch gekennzeichnet, dass**
der auf das Substrat aufgebrachte Lösungsfilm getrocknet wird, indem dieses in einer neutralen Atmosphäre oder an der freien Luft allmählich bis auf eine Temperatur zwischen 150 °C und 300 °C erhitzt wird, um eine feste Schicht zu erhalten.

14. Verfahren nach Anspruch 1,
**dadurch gekennzeichnet, dass**
die feste Schicht, die das Substrat bedeckt, durch thermische Reaktion, die bei einer Temperatur zwischen 300 °C und 650 °C durchgeführt wird, in Chalcopyrit umgewandelt wird, indem die feste Schicht während eines Zeitraums zwischen 1 und 30 Minuten, vorzugsweise 5 und 20 Minuten, mit einer Atmosphäre in Kontakt gebracht wird, die mindestens ein Element wie Selen, Schwefel oder Tellur oder einem Gemisch dieser drei Elemente im elementaren Zustand enthält.

15. Verfahren nach den Ansprüchen 1 und 2,
**dadurch gekennzeichnet, dass**
das erhaltene Chalcopyrit Cadmiumtellurit (CdTe) ist.

16. Verfahren nach den Ansprüchen 1 und 12,
**dadurch gekennzeichnet, dass**
das erhaltene Chalcopyrit CulnₓGa_{y}Se2 ist, wobei die Summe x + y zwischen 0,8 und 1,5 liegt und y zwischen 0 und 0,6 liegt.
